# EUROPÄISCHE PATENTSCHRIFT

(11) **EP 4 605 758 B1**
(45) Veröffentlichungstag und Bekanntmachung des Hinweises auf die Patenterteilung: **09.12.2026**
(21) Anmeldenummer: 23786000.2
(22) Anmeldetag: 02.10.2023
(51) Int. Cl.: G01R 15/24

(54) **MESSEN EINES ELEKTRISCHEN STROMS MIT ZWEI OPTISCHEN STROMWANDLERN**
MEASURING AN ELECTRICAL CURRENT USING TWO OPTICAL CURRENT TRANSFORMERS
MESURE D'UN COURANT ÉLECTRIQUE À L'AIDE DE DEUX TRANSFORMATEURS DE COURANT OPTIQUE

(30) Priorität: 18.10.2022 DE 102022210973
(43) Veröffentlichungstag der Anmeldung: 27.08.2025
(73) Patentinhaber: HSP Hochspannungsgeräte GmbH, 53842 Troisdorf (DE)
(72) Erfinder: SCHUBERTH, Stefan, 96215 Lichtenfels-Schney (DE)
(74) Vertreter: Betten & Resch
(86) Internationale Anmeldenummer: PCT/EP2023/077232
(87) Internationale Veröffentlichungsnummer: WO 2024/083489

(56) Entgegenhaltungen:
- EP-B1- 0 864 098
- WO-A1-96/06359
- WO-A1-98/05975
- US-A- 4 564 754
- LIM C S ET AL: "HYBRID FIBER-OPTIC CURRENT SENSOR USING TWO FARADAY GLASS-SLAB MAGNETIC FIELD SENSORS", JAPANESE JOURNAL OF APPLIED PHYSICS, JAPAN SOCIETY OF APPLIED PHYSICS, JP, vol. 43, no. 5A, 1 May 2004 (2004-05-01), pages 2737 - 2741, XP001231083, ISSN: 0021-4922, DOI: 10.1143/JJAP.43.2737

## Beschreibung

Die Erfindung betrifft die Messung eines elektrischen Stroms unter Verwendung eines optischen Stromwandlers.

Unter einem optischen Stromwandler wird hier eine optische Messvorrichtung zum Messen eines elektrischen Stroms in einem Stromleiter verstanden, die auf dem magnetooptischen Faraday-Effekt beruht. Unter diesem Effekt versteht man die Drehung der Polarisationsrichtung einer linear polarisierten elektromagnetischen Welle in einem Medium durch ein zur Ausbreitungsrichtung der Welle paralleles Magnetfeld. Die Drehung der Polarisationsrichtung ist dabei proportional zu der magnetischen Flussdichte des Magnetfelds.

Bei einem optischen Stromwandler wird linear polarisiertes Licht durch einen in der Nähe des Stromleiters angeordneten Lichtleiter gesendet, der den Faraday-Effekt zeigt. Das von dem Strom in dem Stromleiter erzeugte Magnetfeld bewirkt eine Drehung der Polarisationsrichtung des Lichts. Da die magnetische Flussdichte des Magnetfelds von der Stromstärke des Stroms abhängt, lässt sich die Stromstärke messen, indem die Drehung der Polarisationsrichtung des Lichts erfasst wird. Um die Drehung der Polarisationsrichtung zu erfassen, wird das von dem Lichtleiter ausgegebene Licht beispielsweise durch einen Polarisator geführt und es wird eine Lichtintensität des von dem Polarisator transmittierten Lichts erfasst.

Das Messprinzip eines optischen Stromwandlers impliziert, dass die Messsignale des Stromwandlers keine eindeutige Funktion der Stromstärke des zu messenden Stroms liefern, da verschiedene Stromstärken zu demselben Messsignal führen. Die Werte der Stromstärke bilden aufeinander folgende Eindeutigkeitsbereiche, in denen das Messsignal des Stromwandlers mit steigender Stromstärke jeweils monoton steigt oder fällt. Dabei folgt auf jeden Eindeutigkeitsbereich, in dem das Messsignal des Stromwandlers mit steigender Stromstärke von einem Minimum zu einem Maximum monoton steigt, ein Eindeutigkeitsbereich, in dem das Messsignal des Stromwandlers mit steigender Stromstärke von dem Maximum zu dem Minimum monoton fällt, und auf jeden Eindeutigkeitsbereich, in dem das Messsignal des Stromwandlers mit steigender Stromstärke von dem Maximum zu dem Minimum monoton fällt, folgt ein Eindeutigkeitsbereich, in dem das Messsignal des Stromwandlers mit steigender Stromstärke von dem Minimum zu dem Maximum monoton steigt.

Das Dokument WO 98/05975 A1 offenbart bei der optischen Erfassung einer elektrischen Größe eine periodische Abhängigkeit zwischen optischem Meßsignal und der Meßgröße und die Verwendung von zwei optischen, periodisch abhängigen Meßsignalen, deren Meßwerte als Wertepaar zur eindeutigen Zuordnung eines absoluten Wertes der elektrischen Größe dienen.

Das Dokument EP 0 864 098 B1 offenbart ein Verfahren und eine Anordnung zum Messen einer Meßgröße, bei dem aus einem ersten Meßsignal und einem zweiten Meßsignal ein drittes Meßsignal abgeleitet wird, das im Meßbereich eindeutig ist und wenigstens die gleiche Meßauflösung wie das zweite Meßsignal aufweist.

Der Erfindung liegt die Aufgabe zugrunde, ein verbessertes Verfahren und eine verbesserte Messvorrichtung zum Messen eines elektrischen Stroms unter Verwendung eines optischen Stromwandlers anzugeben.

Die Aufgabe wird erfindungsgemäß durch ein Verfahren mit den Merkmalen des Anspruchs 1 und durch eine Messvorrichtung mit den Merkmalen des Anspruchs 7 gelöst.

Vorteilhafte Ausgestaltungen der Erfindung sind Gegenstand der Unteransprüche.

Bei dem erfindungsgemäßen Verfahren zum Messen eines elektrischen Stroms werden mit wenigstens zwei optischen Stromwandlern jeweils wiederholt von dem Strom abhängige Messsignale erfasst, wobei die Stromwandler voneinander verschiedene Eindeutigkeitsbereiche aufweisen, in denen das von dem jeweiligen Stromwandler erfasste Messsignal bei steigendem Strom monoton zu- oder abnimmt. Für jeden Stromwandler wird fortlaufend ein Vorzeichenwert bestimmt, der das Vorzeichen der ersten Ableitung des von dem Stromwandler erfassten Messsignals nach dem Strom angibt. Den Messsignalen eines Stromwandlers wird ein geänderter Eindeutigkeitsbereich des Stromwandlers zugeordnet, wenn sich der für diesen Stromwandler bestimmte Vorzeichenwert ändert und sich der für wenigstens einen anderen Stromwandler bestimmte Vorzeichenwert nicht ändert. Aus den Messsignalen wenigstens eines Stromwandlers wird die Stromstärke des elektrischen Stroms bestimmt.

Das erfindungsgemäße Verfahren sieht also vor, mehrere optische Stromwandler zum Messen eines elektrischen Stroms zu verwenden, wobei die optischen Stromwandler voneinander verschiedene Eindeutigkeitsbereiche aufweisen, in denen das von dem jeweiligen Stromwandler erfasste Messsignal bei steigendem Strom monoton zu- oder abnimmt. Durch die Verwendung mehrerer optische Stromwandler mit voneinander verschiedenen Eindeutigkeitsbereichen kann das Problem der Mehrdeutigkeit des Messsignals eines optischen Stromwandlers als Funktion des zu messenden Stroms gelöst werden, indem wenigstens ein weiterer optischer Stromwandler genutzt wird, um den jeweiligen Eindeutigkeitsbereich dieses optischen Stromwandlers zu bestimmen. Um den Wechsel zwischen verschiedenen Eindeutigkeitsbereichen optischer Stromwandler zuverlässig festzustellen, sieht die Erfindung vor, für jeden dieser Stromwandler fortlaufend einen Vorzeichenwert zu bestimmen, der das Vorzeichen der ersten Ableitung des von dem Stromwandler erfassten Messsignals nach dem Strom angibt. Der Wechsel des Vorzeichenwertes eines Stromwandlers bei ausbleibendem Wechsel des Vorzeichenwertes eines anderen Stromwandlers signalisiert zuverlässig, dass sich der Eindeutigkeitsbereich des Stromwandlers geändert hat.

Bei einer Ausgestaltung des erfindungsgemäßen Verfahrens weist kein Stromwandler einen Eindeutigkeitsbereich auf, der ein Vielfaches eines Eindeutigkeitsbereichs eines anderen Stromwandlers ist. Diese Ausgestaltung der Erfindung berücksichtigt, dass ein Eindeutigkeitsbereich eines Stromwandlers, der ein Vielfaches eines Eindeutigkeitsbereiches eines anderen Stromwandlers ist, dazu führt, dass es Stromstärken des zu messenden elektrischen Stroms gibt, bei denen sich die Eindeutigkeitsbereiche beider Stromwandler gleichzeitig ändern, so dass es bei diesen Stromstärken nicht möglich ist, einen Stromwandler zur Kontrolle des anderen Stromwandlers zu nutzen.

Bei einer weiteren Ausgestaltung des erfindungsgemäßen Verfahrens sind die Messsignale jedes Stromwandlers digitalisierte Messsignale, die Werte aus einem dem Stromwandler zugeordneten Wertebereich annehmen, und der gesamte Wertebereich wird für jeden Eindeutigkeitsbereich des Stromwandlers genutzt. Diese Ausgestaltung der Erfindung nutzt aus, dass die Erfindung eine eindeutige Bestimmung des jeweiligen Eindeutigkeitsbereiches eines optischen Stromwandlers ermöglicht. Daher kann für jeden Eindeutigkeitsbereich eines Stromwandlers der gesamte diesem Stromwandler zugeordnete Wertebereich für die Aufnahme digitaler Messsignale genutzt werden. Mit anderen Worten braucht unterschiedlichen Eindeutigkeitsbereichen nicht jeweils eine separate Untermenge des Wertebereichs zugeordnet werden. Dadurch wird der Speicherbedarf für die digitalen Messsignale bei gleichbleibender Auflösung der Messsignale vorteilhaft deutlich reduziert beziehungsweise die Auflösung der Messsignale wird bei gleichbleibendem Speicherplatz vorteilhaft deutlich erhöht.

Bei einer weiteren Ausgestaltung des erfindungsgemäßen Verfahrens weist jeder Stromwandler einen Lichtwellenleiter auf und die Lichtwellenleiter wenigstens zweier Stromwandler sind aus voneinander verschiedenen Materialien, insbesondere aus Materialien mit voneinander verschiedenen Verdet-Konstanten, gefertigt.

Bei einer weiteren Ausgestaltung des erfindungsgemäßen Verfahrens wird durch jeden Stromwandler elektromagnetische Strahlung einer für den Stromwandler spezifischen Wellenlänge geführt und die Wellenlängen wenigstens zweier Stromwandler unterscheiden sich voneinander.

Die beiden vorgenannten Ausgestaltungen der Erfindung ermöglichen die Ausbildung optischer Stromwandler mit voneinander verschiedenen Eindeutigkeitsbereichen durch Lichtwellenleiter unterschiedlicher Materialien und/oder elektromagnetischer Strahlung unterschiedlicher Wellenlängen.

Eine erfindungsgemäße Messvorrichtung zum Messen eines elektrischen Stroms umfasst
- wenigstens zwei optische Stromwandler, die jeweils eingerichtet sind, wiederholt von dem Strom abhängige Messsignale zu erfassen, wobei die Stromwandler voneinander verschiedene Eindeutigkeitsbereiche aufweisen, in denen das von dem jeweiligen Stromwandler erfasste Messsignal bei steigendem Strom monoton zu- oder abnimmt, und
- eine Auswerteeinheit, die eingerichtet ist,
- für jeden Stromwandler fortlaufend einen Vorzeichenwert zu bestimmen, der das Vorzeichen der ersten Ableitung des von dem Stromwandler erfassten Messsignals nach dem Strom angibt,
- den Messsignalen eines Stromwandlers einen geänderten Eindeutigkeitsbereich des Stromwandlers zuzuordnen, wenn sich der für diesen Stromwandler bestimmte Vorzeichenwert ändert und sich der für wenigstens einen anderen Stromwandler bestimmte Vorzeichenwert nicht ändert, und
- aus den Messsignalen wenigstens eines Stromwandlers die Stromstärke des elektrischen Stroms zu bestimmen.

Eine erfindungsgemäße Messvorrichtung zum Messen eines elektrischen Stroms ermöglicht die Durchführung des erfindungsgemäßen Verfahrens. Die Vorteile einer derartigen Messvorrichtung korrespondieren daher zu den oben genannten Vorteilen des erfindungsgemäßen Verfahrens. Entsprechendes gilt für die folgenden Ausgestaltungen einer erfindungsgemäßen Messvorrichtung, die zu oben genannten Ausgestaltungen des erfindungsgemäßen Verfahrens korrespondieren.

Bei einer Ausgestaltung der erfindungsgemäßen Messvorrichtung weist kein Stromwandler einen Eindeutigkeitsbereich auf, der ein Vielfaches eines Eindeutigkeitsbereichs eines anderen Stromwandlers ist.

Bei einer weiteren Ausgestaltung der erfindungsgemäßen Messvorrichtung sind die Messsignale jedes Stromwandlers digitalisierte Messsignale, die Werte aus einem dem Stromwandler zugeordneten Wertebereich annehmen, und die Auswerteeinheit ist eingerichtet, den gesamten Wertebereich für jeden Eindeutigkeitsbereich des Stromwandlers zu nutzen.

Bei einer weiteren Ausgestaltung der erfindungsgemäßen Messvorrichtung weist jeder Stromwandler einen Lichtwellenleiter auf und die Lichtwellenleiter wenigstens zweier Stromwandler sind aus voneinander verschiedenen Materialien, insbesondere aus Materialien mit voneinander verschiedenen Verdet-Konstanten, gefertigt.

Bei einer weiteren Ausgestaltung der erfindungsgemäßen Messvorrichtung ist jeder Stromwandler eingerichtet, elektromagnetische Strahlung einer für den Stromwandler spezifischen Wellenlänge zu führen und die Wellenlängen wenigstens zweier Stromwandler unterscheiden sich voneinander.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Blockdiagramm eines Ausführungsbeispiels einer Messvorrichtung zum Messen eines elektrischen Stroms,
FIG 2 Messsignale eines optischen Stromwandlers in Abhängigkeit von einem elektrischen Strom,
FIG 3 ein Ablaufdiagramm eines Ausführungsbeispiels eines Verfahrens zum Messen eines elektrischen Stroms.

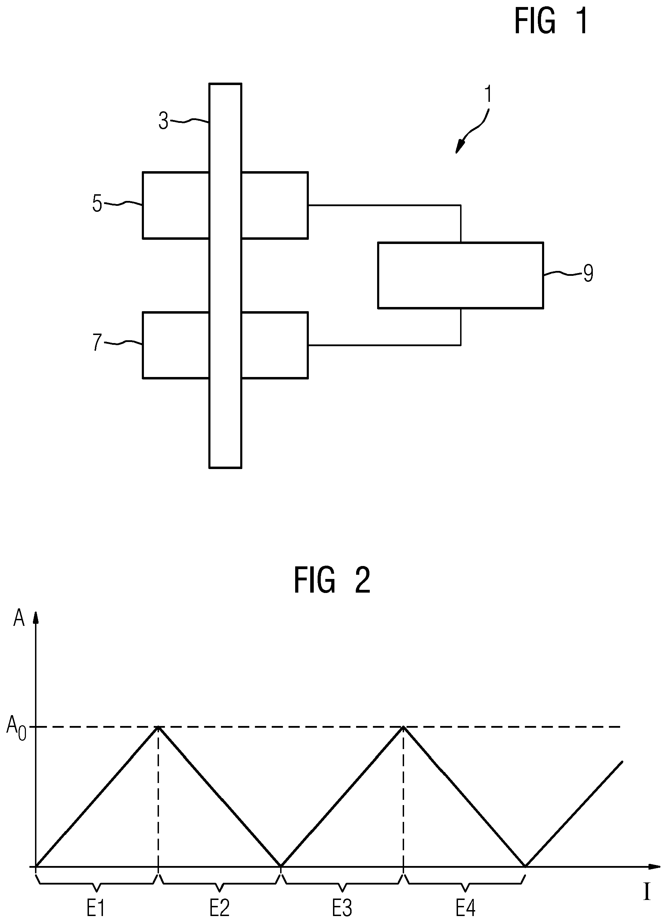

Figur 1 (FIG 1) zeigt ein Blockdiagramm eines Ausführungsbeispiels einer Messvorrichtung 1 zum Messen eines in einem elektrischen Leiter 3 fließenden elektrischen Stroms I. Die Messvorrichtung 1 umfasst zwei optische Stromwandler 5, 7 und eine Auswerteeinheit 9.

Jeder Stromwandler 5, 7 ist eingerichtet, wiederholt von dem Strom I abhängige Messsignale A zu erfassen.

Figur 2 (FIG 2) zeigt schematisch von einem Stromwandler 5, 7 erfasste Messsignale A in Abhängigkeit von dem elektrischen Strom I. Jeder Stromwandler 5, 7 weist Eindeutigkeitsbereiche E1 bis E4 auf, in denen das von dem Stromwandler 5, 7 erfasste Messsignal A bei steigendem Strom I monoton zu- oder abnimmt. Figur 2 zeigt beispielhaft zwei Eindeutigkeitsbereiche E1, E3, in denen das Messsignal A bei steigendem Strom I von dem Wert A=0 zu einem Maximalwert A=A₀ monoton zunimmt, und zwei Eindeutigkeitsbereiche E2, E4, in denen das Messsignal A bei steigendem Strom I von dem Maximalwert A=A₀ zu dem Wert A=0 monoton abnimmt. An jeden Eindeutigkeitsbereich E1, E3, in dem das Messsignal A bei steigendem Strom I monoton zunimmt, schließt sich ein Eindeutigkeitsbereich E2, E4 an, in dem das Messsignal A bei steigendem Strom I monoton abnimmt. An jeden Eindeutigkeitsbereich E2, E4, in dem das Messsignal A bei steigendem Strom I monoton abnimmt, schließt sich ein Eindeutigkeitsbereich E1, E3 an, in dem das Messsignal A bei steigendem Strom I monoton zunimmt.

Die beiden Stromwandler 5, 7 der Messvorrichtung 1 weisen voneinander verschiedene Eindeutigkeitsbereiche E1 bis E4 auf, wobei kein Stromwandler 5, 7 einen Eindeutigkeitsbereich E1 bis E4 aufweist, der ein Vielfaches eines Eindeutigkeitsbereichs E1 bis E4 des anderen Stromwandlers 5, 7 ist. Beispielsweise weisen die Stromwandler 5, 7 jeweils einen Lichtwellenleiter auf und die Lichtwellenleiter der beiden Stromwandler 5, 7 sind aus voneinander verschiedenen Materialien, insbesondere aus Materialen mit voneinander verschiedenen Verdet-Konstanten, gefertigt. Alternativ oder zusätzlich wird durch jeden Stromwandler 5, 7 elektromagnetische Strahlung einer für den Stromwandler 5, 7 spezifischen Wellenlänge geführt, wobei sich die Wellenlängen der beiden Stromwandler 5, 7 voneinander unterscheiden.

Die Auswerteeinheit 9 ist eingerichtet, für jeden Stromwandler 5, 7 fortlaufend einen Vorzeichenwert zu bestimmen, der das Vorzeichen der ersten Ableitung des von dem Stromwandler 5, 7 erfassten Messsignals A nach dem Strom I angibt. Ferner ist die Auswerteeinheit 9 eingerichtet, den Messsignalen A jedes Stromwandlers 5, 7 einen geänderten Eindeutigkeitsbereich E1 bis E4 des Stromwandlers 5, 7 zuzuordnen, wenn sich der für diesen Stromwandler 5, 7 bestimmte Vorzeichenwert ändert und sich der für den anderen Stromwandler 5, 7 bestimmte Vorzeichenwert nicht ändert. Des Weiteren ist die Auswerteeinheit 9 eingerichtet, aus den Messsignalen A wenigstens eines Stromwandlers 5, 7 die Stromstärke des elektrischen Stroms I zu bestimmen. Beispielsweise ist die Auswerteeinheit 9 eingerichtet, die Stromstärke des elektrischen Stroms I aus den Messsignalen A desjenigen Stromwandlers 5, 7 zu bestimmen, der von den beiden Stromwandlern 5, 7 die höhere Messempfindlichkeit aufweist. Alternativ ist die Auswerteeinheit 9 beispielsweise eingerichtet, die Stromstärke des elektrischen Stroms I aus einem Mittelwert oder gewichteten Mittelwert der Messsignale A beider Stromwandler 5, 7 zu bestimmen.

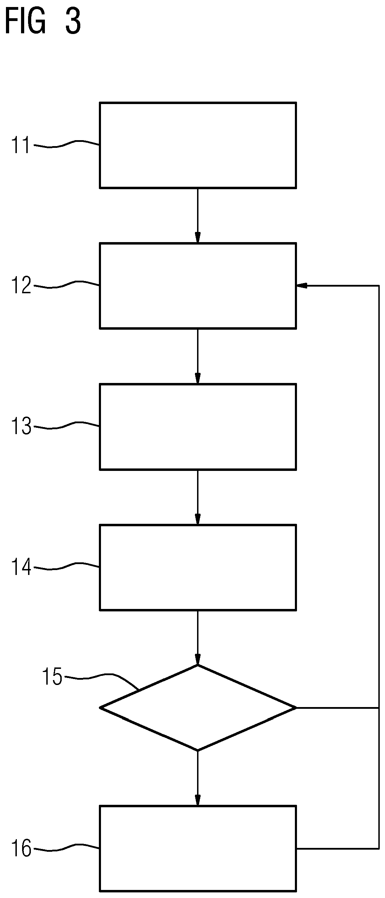

Figur 3 (FIG 3) zeigt ein Ablaufdiagramm eines Ausführungsbeispiels des erfindungsgemäßen Verfahrens zum Messen eines elektrischen Stroms I. Das Verfahren wird mit einer anhand von den Figuren 1 und 2 beschriebenen Messvorrichtung 1 ausgeführt.

In einem ersten Verfahrensschritt 11 wird eine von der Auswerteeinheit 9 auszuführende Berechnungsvorschrift vorgegeben, mit der aus von den Stromwandlern 5, 7 erfassten Messsignalen A die Stromstärke des in dem elektrischen Leiter 3 fließenden elektrischen Stroms I bestimmt wird. Beispielsweise sieht die Berechnungsvorschrift vor, die Stromstärke des elektrischen Stroms I aus den Messsignalen A desjenigen Stromwandlers 5, 7 zu bestimmen, der von den beiden Stromwandlern 5, 7 die höhere Messempfindlichkeit aufweist. Die Berechnungsvorschrift hängt dabei von dem zu der Stromstärke korrespondierenden Eindeutigkeitsbereich E1 bis E4 des Stromwandlers 5, 7 ab. Wenn die Messsignale A des Stromwandlers 5, 7 beispielsweise wie in dem in Figur 2 gezeigten Beispiel in den Eindeutigkeitsbereichen E1 bis E4 jeweils linear von dem Strom I abhängen, ist die Berechnungsvorschrift in dem Eindeutigkeitsbereich E1 von der Form I = f·A mit einer Proportionalitätskonstante f, in dem Eindeutigkeitsbereich E2 ist die Berechnungsvorschrift von der Form I = f·(2A₀ - A) usw.

Alternativ sieht die Berechnungsvorschrift beispielsweise vor, die Stromstärke des elektrischen Stroms I aus einem Mittelwert oder gewichteten Mittelwert der Messsignale A beider Stromwandler 5, 7 zu bestimmen. Die Berechnungsvorschrift hängt dabei entsprechend von den zu der Stromstärke korrespondierenden Eindeutigkeitsbereichen E1 bis E4 der Stromwandler 5, 7 ab.

Nach dem ersten Verfahrensschritt 11 wird ein zweiter Verfahrensschritt 12 durchgeführt.

In dem zweiten Verfahrensschritt 12 wird von jedem Stromwandler 5, 7 ein von dem Strom I abhängiges Messsignal A erfasst. Das Messsignal A jedes Stromwandlers 5, 7 ist ein von einem Analog-Digital-Umsetzer digitalisiertes Messsignal, das einen Wert aus einem die Auflösung des Analog-Digital-Umsetzers bestimmenden Wertebereich annimmt. Dabei können für die beiden Stromwandler 5, 7 verschiedene Analog-Digital-Umsetzer, insbesondere Analog-Digital-Umsetzer mit voneinander verschiedenen Wertebereichen, verwendet werden.

Beispielsweise wird für einen ersten Stromwandler 5, 7 ein 8-Bit-Analog-Digital-Umsetzer verwendet, dessen Wertebereich also 256 Werte umfasst, und für den zweiten Stromwandler 5, 7 wird ein 16-Bit-Analog-Digital-Umsetzer verwendet, dessen Wertebereich also 65536 Werte umfasst. In diesem Beispiel werden vorzugsweise die Messsignale A des zweiten Stromwandlers 5, 7 verwendet, um die Stromstärke des Stroms I zu bestimmen, und der erste Stromwandler 5, 7 wird verwendet, um die Messsignale A des zweiten Stromwandlers 5, 7 zu plausibilisieren.

Der gesamte Wertebereich des einem Stromwandler 5, 7 zugeordneten Analog-Digital-Umsetzers wird dabei für alle Messsignale A in dem jeweiligen Eindeutigkeitsbereich E1 bis E4 des Stromwandlers 5, 7 genutzt.

Nach dem zweiten Verfahrensschritt 12 wird ein dritter Verfahrensschritt 13 durchgeführt.

In dem dritten Verfahrensschritt 13 wird von der Auswerteeinheit 9 aus den im zweiten Verfahrensschritt 12 erfassten Messsignalen A die Stromstärke des Stroms I gemäß der jeweils aktuellen Berechnungsvorschrift bestimmt.

Nach dem dritten Verfahrensschritt 13 wird ein vierter Verfahrensschritt 14 durchgeführt.

In dem vierten Verfahrensschritt 14 wird von der Auswerteeinheit 9 für jeden Stromwandler 5, 7 ein Vorzeichenwert bestimmt, der das Vorzeichen der ersten Ableitung des von dem Stromwandler 5, 7 erfassten Messsignals A nach dem Strom I angibt. Dazu werden von der Auswerteeinheit 9 zeitlich aufeinander folgende Messsignale A jedes Stromwandlers 5, 7 ausgewertet.

Nach dem vierten Verfahrensschritt 14 wird ein fünfter Verfahrensschritt 15 durchgeführt.

In dem fünften Verfahrensschritt 15 wird von der Auswerteeinheit 9 geprüft, ob sich der in dem vierten Verfahrensschritt 14 für einen Stromwandler 5, 7, dessen Messsignale A zur Bestimmung der Stromstärke des Stroms I verwendet werden, ermittelte Vorzeichenwert gegenüber dem bisherigen Vorzeichenwert für diesen Stromwandler 5, 7 verändert hat. Wenn dies nicht der Fall ist, wird nach dem Verfahrensschritt 15 wieder der zweite Verfahrensschritt 12 ausgeführt. Andernfalls wird ein sechster Verfahrensschritt 16 durchgeführt.

In dem sechsten Verfahrensschritt 16 wird die Berechnungsvorschrift, mit der aus von den Stromwandlern 5, 7 erfassten Messsignalen A die Stromstärke des in dem elektrischen Leiter 3 fließenden elektrischen Stroms I bestimmt wird, geändert. Dabei wird demjenigen Stromwandler 5, 7, für den in dem fünften Verfahrensschritt 15 ein geänderter Vorzeichenwert festgestellt wurde, ein Eindeutigkeitsbereich E1 bis E4 zugeordnet, der an den diesem Stromwandler 5, 7 vorher zugeordneten Eindeutigkeitsbereich E1 bis E4 grenzt und zu der jeweils aktuellen Stromstärke korrespondiert, und die Berechnungsvorschrift wird dem geänderten Eindeutigkeitsbereich E1 bis E4 des Stromwandlers 5, 7 angepasst.

Nach dem sechsten Verfahrensschritt 16 wird wieder der zweite Verfahrensschritt 12 durchgeführt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Messen eines elektrischen Stroms (I), wobei
- mit wenigstens zwei optischen Stromwandlern (5, 7) jeweils wiederholt von dem Strom (I) abhängige Messsignale (A) erfasst werden, wobei die Stromwandler (5, 7) voneinander verschiedene Eindeutigkeitsbereiche (E1 bis E4) aufweisen, in denen das von dem jeweiligen Stromwandler (5, 7) erfasste Messsignal (A) bei steigendem Strom (I) monoton zu- oder abnimmt, und
- aus den Messsignalen (A) wenigstens eines Stromwandlers (5, 7) die Stromstärke des elektrischen Stroms (I) bestimmt wird,
**dadurch gekennzeichnet, dass**
- für jeden Stromwandler (5, 7) fortlaufend ein Vorzeichenwert bestimmt wird, der das Vorzeichen der ersten Ableitung des von dem Stromwandler (5, 7) erfassten Messsignals (A) nach dem Strom (I) angibt, und
- den Messsignalen (A) eines Stromwandlers (5, 7) ein geänderter Eindeutigkeitsbereich (E1 bis E4) des Stromwandlers (5, 7) zugeordnet wird, wenn sich der für diesen Stromwandler (5, 7) bestimmte Vorzeichenwert ändert und sich der für wenigstens einen anderen Stromwandler (5, 7) bestimmte Vorzeichenwert nicht ändert.

2. Verfahren nach Anspruch 1, wobei kein Stromwandler (5, 7) einen Eindeutigkeitsbereich (E1 bis E4) aufweist, der ein Vielfaches eines Eindeutigkeitsbereichs (E1 bis E4) eines anderen Stromwandlers (5, 7) ist.

3. Verfahren nach Anspruch 1 oder 2, wobei die Messsignale (A) jedes Stromwandlers (5, 7) digitalisierte Messsignale sind, die Werte aus einem dem Stromwandler (5, 7) zugeordneten Wertebereich annehmen, und wobei der gesamte Wertebereich für jeden Eindeutigkeitsbereich (E1 bis E4) des Stromwandlers (5, 7) genutzt wird.

4. Verfahren nach einem der vorhergehenden Ansprüche, wobei jeder Stromwandler (5, 7) einen Lichtwellenleiter aufweist und die Lichtwellenleiter wenigstens zweier Stromwandler (5, 7) aus voneinander verschiedenen Materialien gefertigt sind.

5. Verfahren nach Anspruch 4, wobei die Lichtwellenleiter wenigstens zweier Stromwandler (5, 7) aus Materialen mit voneinander verschiedenen Verdet-Konstanten gefertigt sind.

6. Verfahren nach einem der vorhergehenden Ansprüche, wobei durch jeden Stromwandler (5, 7) elektromagnetische Strahlung einer für den Stromwandler (5, 7) spezifischen Wellenlänge geführt wird und sich die Wellenlängen wenigstens zweier Stromwandler (5, 7) voneinander unterscheiden.

7. Messvorrichtung (1) zum Messen eines elektrischen Stroms (I), umfassend
- wenigstens zwei optische Stromwandler (5, 7), die jeweils eingerichtet sind, wiederholt von dem Strom (I) abhängige Messsignale (A) zu erfassen, wobei die Stromwandler (5, 7) voneinander verschiedene Eindeutigkeitsbereiche (E1 bis E4) aufweisen, in denen das von dem jeweiligen Stromwandler (5, 7) erfasste Messsignal (A) bei steigendem Strom (I) monoton zu- oder abnimmt, und
- eine Auswerteeinheit (9), die eingerichtet ist,
- aus den Messsignalen (A) wenigstens eines Stromwandlers (5, 7) die Stromstärke des elektrischen Stroms (I) zu bestimmen,
**dadurch gekennzeichnet, dass** die Auswerteeinheit weiterhin eingerichtet ist,
- für jeden Stromwandler (5, 7) fortlaufend einen Vorzeichenwert zu bestimmen, der das Vorzeichen der ersten Ableitung des von dem Stromwandler (5, 7) erfassten Messsignals (A) nach dem Strom (I) angibt, und
- den Messsignalen (A) eines Stromwandlers (5, 7) einen geänderten Eindeutigkeitsbereich (E1 bis E4) des Stromwandlers (5, 7) zuzuordnen, wenn sich der für diesen Stromwandler (5, 7) bestimmte Vorzeichenwert ändert und sich der für wenigstens einen anderen Stromwandler (5, 7) bestimmte Vorzeichenwert nicht ändert.

8. Messvorrichtung (1) nach Anspruch 7, wobei kein Stromwandler (5, 7) einen Eindeutigkeitsbereich (E1 bis E4) aufweist, der ein Vielfaches eines Eindeutigkeitsbereichs (E1 bis E4) eines anderen Stromwandlers (5, 7) ist.

9. Messvorrichtung (1) nach Anspruch 7 oder 8, wobei die Messsignale (A) jedes Stromwandlers (5, 7) digitalisierte Messsignale sind, die Werte aus einem dem Stromwandler (5, 7) zugeordneten Wertebereich annehmen, und die Auswerteeinheit (9) eingerichtet ist, den gesamten Wertebereich für jeden Eindeutigkeitsbereich (E1 bis E4) des Stromwandlers (5, 7) zu nutzen.

10. Messvorrichtung (1) nach einem der Ansprüche 7 bis 9, wobei jeder Stromwandler (5, 7) einen Lichtwellenleiter aufweist und die Lichtwellenleiter wenigstens zweier Stromwandler (5, 7) aus voneinander verschiedenen Materialien gefertigt sind.

11. Messvorrichtung (1) nach Anspruch 10, wobei die Lichtwellenleiter wenigstens zweier Stromwandler (5, 7) aus Materialen mit voneinander verschiedenen Verdet-Konstanten gefertigt sind.

12. Messvorrichtung (1) nach einem der Ansprüche 7 bis 11, wobei jeder Stromwandler (5, 7) eingerichtet ist, elektromagnetische Strahlung einer für den Stromwandler (5, 7) spezifischen Wellenlänge zu führen und sich die Wellenlängen wenigstens zweier Stromwandler (5, 7) voneinander unterscheiden.

## Claims

1. Method for measuring an electrical current (I), wherein
- measurement signals (A) dependent on the current (I) are detected repeatedly in each case by means of at least two optical current transformers (5, 7), wherein the current transformers (5, 7) have differing unambiguous ranges (E1 to E4) in which the measurement signal (A) detected by the respective current transformer (5, 7) monotonously increases or decreases as the current increases (I),
- the amperage of the electrical current (I) is determined from the measurement signals (A) from at least one current transformer (5, 7)
**characterised in that**
- a sign value is continually determined for each current transformer (5, 7), the sign value indicating the sign of the first derivative of the measurement signal (A), with respect to the current (I), detected by the current transformer (5, 7), and
- a modified unambiguous range (E1 to E4) of the current transformer (5, 7) is associated with the measurement signals (A) from a current transformer (5, 7) if the sign value determined for this current transformer (5, 7) changes and the sign value determined for at least one other current transformer (5, 7) does not change.

2. Method according to claim 1, wherein no current transformer (5, 7) has an unambiguous range (E1 to E4) that is a multiple of an unambiguous range (E1 to E4) of another current transformer (5, 7).

3. Method according to either claim 1 or claim 2, wherein the measurement signals (A) of each current transformer (5, 7) are digitised measurement signals which can assume values from a value range assigned to the current transformer (5, 7), and wherein the entire value range is used for each unambiguous range (E1 to E4) of the current transformer (5, 7).

4. Method according to any of the preceding claims, wherein each current transformer (5, 7) comprises an optical waveguide and the optical waveguides of at least two current transformers (5, 7) are produced from different materials.

5. Method according to claim 4, wherein the optical waveguides of at least two current transformers (5, 7) are produced from materials having different Verdot constants.

6. Method according to any of the preceding claims, wherein electromagnetic radiation of a wavelength specific for the current transformer (5, 7) is conducted through each current transformer (5, 7), and the wavelengths of at least two current transformers (5, 7) differ from one another.

7. Measuring device (1) for measuring an electrical current (I), comprising
- at least two optical current transformers (5, 7) which are each configured to repeatedly detect measurement signals (A) dependent on the current (I), wherein the current transformers (5, 7) have differing unambiguous ranges (E1 to E4) in which the measurement signal (A) detected by the respective current transformer (5, 7) monotonously increases or decreases as the current (I) increases, and
- an evaluation unit (9), which is configured
- to determine the amperage of the electrical current (I) from the measurement signals (A) of at least one current transformer (5, 7),
**characterised in that** the evaluation unit is further configured,
- to continually determine a sign value for each current transformer (5, 7), which sign value indicates the sign of a first derivative of the measurement signal (A), with respect to the current (I), detected by the current transformer (5, 7), and
- to assign a changed unambiguous range (E1 to E4) of the current transformer (5, 7) to the measurement signals (A) of a current transformer (5, 7) if the sign value determined for this current transformer (5, 7) changes and the sign value determined for the at least one other current transformer (5, 7) does not change.

8. Measuring device (1) according to claim 7, wherein no current transformer (5, 7) has an unambiguous range (E1 to E4) that is a multiple of an unambiguous range (E1 to E4) of another current transformer (5, 7).

9. Measuring device (1) according to either claim 7 or claim 8, wherein the measurement signals (A) of each current transformer (5, 7) are digitised measurement signals which assume values from a value range assigned to the current transformer (5, 7), and the evaluation unit (9) is configured to use the entire value range for each unambiguous range (E1 to E4) of the current transformer (5, 7).

10. Measuring device (1) according to any of claims 7 to 9, wherein each current transformer (5, 7) comprises an optical waveguide and the optical waveguides of at least two current transformers (5, 7) are produced form different materials.

11. Measuring device (1) according to claim 10, wherein the optical waveguides of at least two current transformers (5, 7) are produced from materials having different Verdet constants.

12. Measuring device (1) according to any of claims 7 to 11, wherein each current transformer (5, 7) is configured to conduct electromagnetic radiation of a wavelength specific for the current transformer (5, 7), and the wavelengths of at least two current transformers (5, 7) differ from one another.

## Revendications

1. Procédé de mesure d'un courant électrique (I), dans lequel
- au moins deux transformateurs de courant optiques (5, 7) détectent chacun de manière répétée des signaux de mesure (A) dépendant du courant (I), les transformateurs de courant (5, 7) présentant des plages d'unicité (E1 à E4) différentes les unes des autres, dans lesquelles le signal de mesure (A) détecté par le transformateur de courant respectif (5, 7) diminue ou augmente de façon monotone lorsque le courant (I) augmente, et
- l'intensité du courant électrique (I) est déterminée à partir des signaux de mesure (A) d'au moins un transformateur de courant (5, 7),
**caractérisé en ce que**,
- pour chaque transformateur de courant (5, 7), il est déterminé en continu une valeur de signe qui indique le signe de la dérivée première du signal de mesure (A) détecté par le transformateur de courant (5, 7) par rapport au courant (I), et
- une plage d'unicité modifiée (E1 à E4) du transformateur de courant (5, 7) est associée aux signaux de mesure (A) d'un transformateur de courant (5, 7) lorsque la valeur de signe déterminée pour ce transformateur de courant (5, 7) change alors que la valeur de signe déterminée pour au moins un autre transformateur de courant (5, 7) ne change pas.

2. Procédé selon la revendication 1, dans lequel aucun transformateur de courant (5, 7) ne présente une plage d'unicité (E1 à E4) qui soit un multiple d'une plage d'unicité (E1 à E4) d'un autre transformateur de courant (5, 7).

3. Procédé selon la revendication 1 ou la revendication 2, dans lequel les signaux de mesure (A) sont chacun des signaux de mesure numérisés des transformateurs de courant (5, 7), qui prennent des valeurs issues d'une plage de valeurs associée au transformateur de courant (5, 7), et dans lequel la plage de valeurs totale est utilisée pour chaque plage d'unicité (E1 à E4) du transformateur de courant (5, 7).

4. Procédé selon l'une des revendications précédentes, dans lequel chaque transformateur de courant (5, 7) présente un guide d'ondes optique et les guides d'ondes optiques d'au moins deux transformateurs de courant (5, 7) sont fabriqués à partir de matériaux différents les uns des autres.

5. Procédé selon la revendication 4, dans lequel les fibres optiques d'au moins deux transformateurs de courant (5, 7) sont fabriquées à partir de matériaux présentant des constantes de Verdet différentes les unes des autres.

6. Procédé selon l'une des revendications précédentes, dans lequel un rayonnement électromagnétique d'une longueur d'onde spécifique au transformateur de courant (5, 7) est guidé à travers chaque transformateur de courant (5, 7), et dans lequel les longueurs d'onde d'au moins deux transformateurs de courant (5, 7) diffèrent l'une de l'autre.

7. Dispositif de mesure (1) destiné à mesurer un courant électrique (I), comprenant
- au moins deux transformateurs de courant optiques (5, 7), qui sont chacun agencés de manière à détecter de manière répétée des signaux de mesure (A) dépendant du courant (I), les transformateurs de courant (5, 7) présentant des plages d'unicité (E1 à E4) différentes les unes des autres, dans lesquelles le signal de mesure (A) détecté par le transformateur de courant (5, 7) respectif augmente ou diminue de façon monotone lorsque le courant (I) augmente, et
- une unité d'évaluation (9) qui est agencée de manière à
- déterminer, à partir des signaux de mesure (A) d'au moins un transformateur de courant (5, 7), l'intensité du courant électrique (I),
**caractérisé en ce que** l'unité d'évaluation est en outre agencée de manière à
- déterminer en continu, pour chaque transformateur de courant (5, 7), une valeur de signe indiquant le signe de la dérivée première du signal de mesure (A) détecté par le transformateur de courant (5, 7) par rapport au courant (I), et
- attribuer aux signaux de mesure (A) d'un transformateur de courant (5, 7) une plage d'unicité modifiée (E1 à E4) dudit transformateur de courant (5, 7) lorsque la valeur de signe déterminée pour ce transformateur de courant (5, 7) change alors que la valeur de signe déterminée pour au moins un autre transformateur de courant (5, 7) ne change pas.

8. Dispositif de mesure (1) selon la revendication 7, dans lequel aucun transformateur de courant (5, 7) ne présente une plage d'unicité (E1 à E4) qui soit un multiple d'une plage d'unicité (E1 à E4) d'un autre transformateur de courant (5, 7).

9. Dispositif de mesure (1) selon la revendication 7 ou la revendication 8, dans lequel les signaux de mesure (A) de chaque transformateur de courant (5, 7) sont des signaux de mesure numérisés qui prennent des valeurs issues d'une plage de valeurs associée au transformateur de courant (5, 7), et l'unité d'évaluation (9) est agencée de manière à exploiter l'ensemble de la plage de valeurs pour chaque plage d'unicité (E1 à E4) du transformateur de courant (5, 7).

10. Dispositif de mesure (1) selon l'une des revendications 7 à 9, dans lequel chaque transformateur de courant (5, 7) présente un guide d'ondes optiques, et les guides d'ondes optiques d'au moins deux transformateurs de courant (5, 7) sont fabriqués à partir de matériaux différents les uns des autres.

11. Dispositif de mesure (1) selon la revendication 10, dans lequel les fibres optiques d'au moins deux transformateurs de courant (5, 7) sont fabriquées à partir de matériaux présentant des constantes de Verdet différentes les unes des autres.

12. Dispositif de mesure (1) selon l'une des revendications 7 à 11, dans lequel chaque transformateur de courant (5, 7) est agencé de manière à guider un rayonnement électromagnétique d'une longueur d'onde spécifique au transformateur de courant (5, 7), et les longueurs d'onde d'au moins deux transformateurs de courant (5, 7) diffèrent l'une de l'autre.
